# NEW EUROPEAN PATENT SPECIFICATION

(11) **EP 1 998 447 B2**
(45) Date of publication and mention of the opposition decision: **08.04.2020**
(45) Mention of the grant of the patent: 16.02.2011
(21) Application number: 08103611.3
(22) Date of filing: 18.04.2008
(51) Int. Cl.: H03J 1/00

(54) **Method for estimating the type of broadcast for minimizing the time for channel installation**
Verfahren zur Abschätzung eines Rundfunksignaltyps zur Minimierung der Kanalinstallationszeit
Procédé pour estimer le type de diffusion afin de minimiser le temps d'installation du canal

(30) Priority: 28.05.2007 TR 200703666
(43) Date of publication of application: 03.12.2008
(73) Proprietor: Vestel Elektronik Sanayi ve Ticaret A.S., 45030 Manisa (TR)
(72) Inventor: Sezer, Cem Cabot Izmir Yazilim ve Donanim Tic. San. A.S., IYTE Kampusu, Gulbahce-URLA, IZMIR (TR); Yilmaz, Evren Gokhan Cabot Izmir Yazilim ve Donanim Tic. San. A.S., IYTE Kampusu, Gulbahce-URLA, IZMIR (TR)
(74) Representative: Cayli, Hülya

(56) References cited:
- EP-A1- 1 804 388
- DE-B3-102005 051 696
- GB-A- 2 325 363
- JP-A- 2003 234 975
- US-A- 5 557 337
- US-A1- 2005 140 354
- US-A1- 2005 179 818

## Description

### Technical Field

This invention relates to a method for fast channel search of multiple broadcast types.

### Prior Art

Due to developments in digital broadcasting in recent years, a television receiver requires a function capable of receiving both analog broadcasting and digital broadcasting. But this causes a problem in channel search period. The total time for automatic channel searching extends since much time is taken in order to get a digital broadcasting program in known automatic channel search methods which are performed in a receiver which is capable of receiving both analog and digital broadcasting programs.

In order to solve this problem, several methods have been developed. In prior art, most of the methods are following the steps:
- Search for the analog channel on a frequency
- If it exists then store the channel info in the memory unit.
- If there is no analog channel on that frequency and if there is a broadcast on the same frequency then perform a digital search on that frequency.
- Store the channel(s) if found any.

This search is performed on the whole frequency range. Since the digital channels are only searched on the frequencies that have a broadcast other then analog, search duration is shortened. The published patent applications with the number JP2004088162, JP2004312384 and JP2006024994 are examples of this kind of a solution.

Also the patent JP2004349963 may be regarded as another prior art of channel searching method. In this method, search for the digital channel on the frequency is performed. If there exists any, then the channel information is stored in the memory unit. If there is no digital channel on that frequency then search for analog is performed and the channel info for any found channel is stored. This method only searches analog channels on the frequencies which do not have any digital broadcast.

The patent applications with the number US2005073614 and WO0145257 enclose a method in which the whole frequency range is searched for analog channels. Found analog channels and the frequency info are stored in the memory unit. Then as a second step, search for digital channels is performed on the frequencies which have broadcast other than analog.

All these prior art methods are performing broadcast type discrimination by testing different types in an order. There is no smart decision mechanism. First, analog broadcast is tested, if no, then digital is tested or vice versa. That has a disadvantage of unnecessarily spending time for testing the wrong broadcast type to detect the correct broadcast type.

Also the document KR20050009850 encloses a method for detecting the existence of a digital signal in a digital TV receiver to reduce decoding stand-by time of a decoder by skipping the channels having no signal, the analog signal channels and the channels having null signals when channel search is carried out, in order to minimize user's waiting time. But this method is developed for digital TV receivers, and the power level estimation is used in order to identify whether the signal is digital or not, so it is not a suitable estimation for a system receiving both analog and digital broadcasting.

The patent document US 2005/140354 A1 discloses a fast search method for detecting broadcast at a frequency by measuring the power level at the said frequency, wherein a frequency having a power level above a predefined threshold is considered to be carrying a broadcast. However, the invention disclosed in the document fails to identify the type of broadcast.

### Object of the invention

The object of the present invention is to make an estimation to test the most likely broadcast type first, then the other by using the power level distribution on the given frequency spectrum.

A further object of the invention is to detect the frequency shifts with the help of the power level distribution analysis of the given frequency spectrum, so that providing the channel search to install the channels even if the broadcast is on a shifted frequency.

### Brief Description of the Drawings

Figure 1: A sample power level distribution on a UHF frequency spectrum
Figure 2: The channel search algorithm

### Detailed Description of the Invention

Channel search on multiple broadcast types takes long since the given frequency range may include analog, digital or overlapping analog-digital signals. The invention speeds up this search process by a new method to estimate the broadcast type by the use of power levels which are extracted from the given frequency spectrum. This method can be used on all set top boxes, digital plasma-tft televisions, integrated digital televisions which have the support for multiple broadcast types (like analog, digital).

Broadcast Type Estimation: It is possible to detect power level at a given frequency within a given bandwidth. This power level can be estimated from the Automatic Gain Control (AGC) value at the given central frequency and the bandwidth. Higher AGC means weaker signal power level and vice versa. Therefore, rough power level estimation can easily be done by measuring the AGC value at a given frequency.

Power levels are stored by searching the given frequency spectrum in predetermined steps and recording the power level into a predefined memory unit at each step. Step size and the bandwidth can be configurable.

The power levels stored in the predefined memory are analyzed and broadcast types through the given frequency range are estimated.

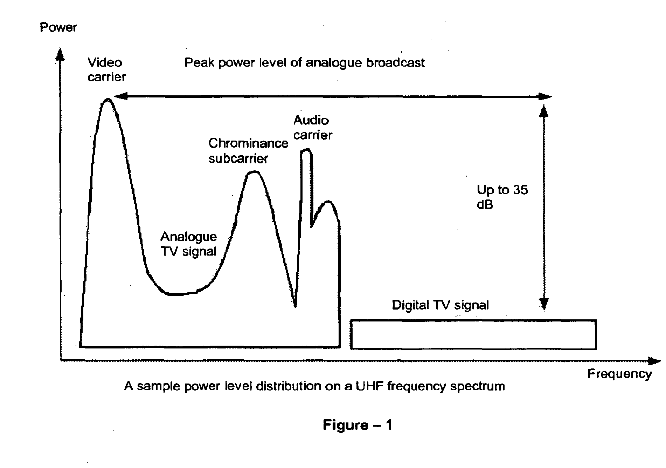

In figure 1, the shown frequency spectrum includes an analog television broadcast and a digital video broadcast next to analog one. There are significant differences between analog and digital broadcast power distributions. These are:
- The power difference between Analog television signal peak synchronous power and the power level of digital television signal might be up to 35 dB(s).
- Digital television signal consists of a number of carriers which makes its frequency distribution smooth along its bandwidth. However, Analog television signal has a different distribution because of its video carrier, chrominance carrier and audio carrier. Therefore the distribution is not smooth.

The power level sampling is performed in a given frequency step size and bandwidth. At each step the power level is calculated and stored into a pre-determined memory unit. The power level distribution is analyzed during the frequency range. If a continuous smooth power level is observed with a reasonable signal to noise ratio, then it is a good point to define that frequency range as a possible digital signal. If a power level change higher than a given threshold is obtained then that frequency range can be marked as a possible analog signal. If there is no power through a frequency range then that range is marked as no signal so that the search algorithm will spend no time for the empty channel.

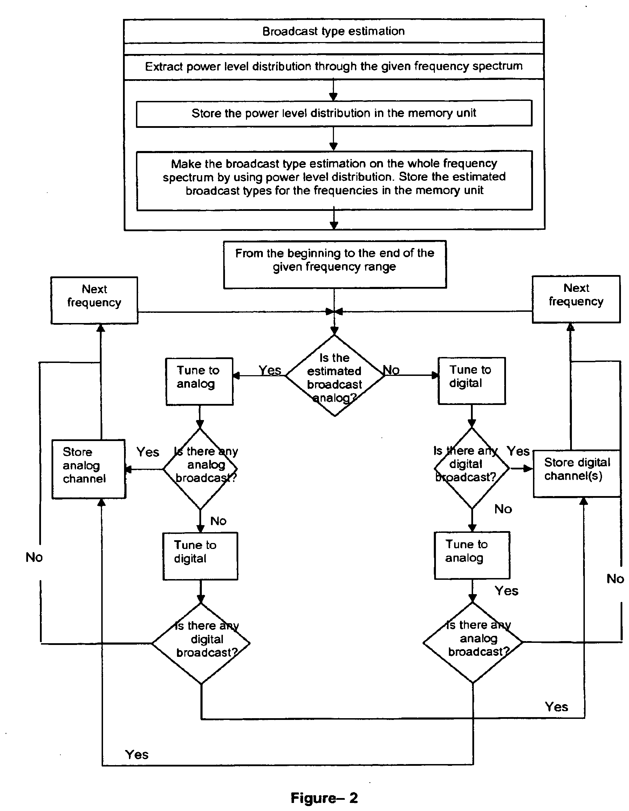

As seen from the flow chart (figure 2), channel search is started after the broadcast type estimation has been done within the given frequency range.

From the beginning of the given frequency range to the end, each frequency step is tested with its estimated broadcast type first. If the broadcast type is correct and channel installation succeeds then the found channel is stored to another predefined memory unit and the next frequency is searched. If channel installation fails with the estimated broadcast type then the other broadcast type is tested. If there is no signal along a frequency range the channel search is skipped for that range. The invention makes a smart estimation for the broadcast type. This invention searches the correct broadcast type in usual cases. Even if the wrong broadcast type is estimated, the correct broadcast type is searched in the next attempt so the channel installation succeeds every time.

The invention performs a fast search on a given frequency range by making a smart broadcast type estimation and using it through the search operation. The power level distribution in a given frequency range is extracted and stored into a predetermined memory unit. Then the data extracted is analyzed to make smart broadcast type estimation for predetermined frequencies. The given frequency range is then searched by the method which tries first the estimated broadcast type, if it fails then tries the other type. Since the most likely broadcast type is tried first, that decreases the probability to check the wrong broadcast type unnecessarily. That speeds up the search process.

Also it will be possible to detect the frequency shifts with the help of the power level distribution analysis on the given frequency spectrum. Even if a broadcast channel is on a shifted frequency, with the help of the power level analysis, the central point of the analog or digital broadcasting can be identified. By using the data obtained in power level analysis, the tuners will be tuned to the central points of the estimated digital or analog signals in channel search procedure. By using this method, the channel search will install the channels even if the broadcast is on a shifted frequency.

## Claims

1. A method for providing a channel search for a system having a first and a second tuner for receiving analog and digital signals within a given frequency spectrum, comprising the steps:
• Determining a frequency spectrum for receiving analog and digital signals
• Searching the given frequency spectrum in predetermined steps
• Extracting power level distribution through said frequency spectrum, where said frequency spectrum contains broadcast signals, and where broadcast signals can be digital broadcast signals or analog broadcast signals
• Calculating the power level within a given bandwidth at each predefined step size
• Storing the power level distribution in a first memory unit
• Estimating broadcast types on the whole frequency spectrum by using the power level distribution
• Storing said estimated broadcast types for said frequency spectrum in the first memory unit.
• Starting the channel search for a frequency range within said frequency spectrum
**characterized in that,** the method further comprises the steps of;
• In order to receive broadcast signals, tuning of said first or said second tuner with respect to the estimated broadcast type
• If said estimated broadcast type matches with received broadcast type, storing the channel in a second memory unit and continuing channel search within said frequency spectrum
• If said estimated broadcast type does not match with said received broadcast type, tuning to the other tuner within the system for storing the channel in said second memory unit and for continuing said channel search.

2. A method according to claim 1 wherein, if said frequency range contains no signal, channel search is skipped for that range.

3. A method according to claim 1 wherein said broadcast type is estimated from the Automatic Gain Control (AGC) value at a given central frequency and the bandwidth.

4. A method according to claim 3 wherein, in said broadcast type estimation procedure, the central frequency of a broadcast signal is identified from the power level analysis.

5. A method according to claim 4 wherein, in the tuning procedure the tuner will be tuned to said central frequency of an estimated broadcast signal in order to prevent failures caused from frequency shifts.

6. A method according to claim 1 wherein said power levels are stored by searching the given frequency range in given steps.

7. A method according to claim 1 wherein said broadcast type estimation is done by analyzing the power levels stored in said first memory.

8. A method according to claim 7 wherein, a frequency range is estimated to be a digital broadcast signal, if a continuous smooth power level is observed with a reasonable signal to noise ratio

9. A method according to claim 7 wherein, a frequency range is marked as an analog signal if a power level change higher than a threshold level is obtained

10. A method according to claim 7 wherein a frequency range is marked as no signal if there is no power through that frequency range

11. A method according to claim 1 wherein, said step size and bandwidth are configurable

12. A method according to claim 1 wherein, said first and said second memory are volatile memories.

13. A method according to claim 1 wherein said first and said second memory are non-volatile memories.

14. A method according to claim 13 wherein said first and second memory are memory locations in a non-volatile memory.

15. A system having a first and a second tuner for receiving analog and digital signals within a given frequency spectrum, comprising:
• means for determining a frequency spectrum for receiving analog and digital signals
• means for searching the given frequency spectrum in predetermined steps
• means for extracting power level distribution through said frequency spectrum, where said frequency spectrum contains broadcast signals and where broadcast signals can be digital broadcast signals or analog broadcast signals
• means for calculating the power level within a given bandwidth at each predefined step size
• a first memory unit for storing the power level distribution
• means for estimating broadcast types on the whole frequency spectrum by using power level distribution
• a first memory unit for storing said estimated broadcast types for said frequency spectrum
• means for channel search for a frequency range within said frequency spectrum
**characterized in that,** it further comprises;
• means for tuning to said first or said second tuner with respect to estimated broadcast type
• means for deciding whether the estimated broadcast type matches with received broadcast type
• a second memory unit for storing the found channels if said estimated broadcast type matches with received broadcast type
• if said estimated broadcast type does not match with said received broadcast type, tuning to the other tuner within the system for storing the channel in said second memory unit and for continuing said channel search.

16. A system according to claim 15 wherein, if said frequency range contains no signal, channel search is skipped for that range.

## Patentansprüche

1. Verfahren zum Durchführen einer Kanalsuche für ein System mit einem ersten und einem zweiten Kanalwähler zum Empfangen analoger und digitaler Signale innerhalb eines bestimmten Frequenzspektrums, folgende Schritte umfassend:
• Bestimmen eines Frequenzspektrums zum Empfangen analoger und digitaler Signale
• Durchsuchen des bestimmten Frequenzspektrums in vorbestimmten Schritten
• Extrahieren einer Leistungspegelverteilung über das Frequenzspektrum, wobei das Frequenzspektrum Rundfunksignale enthält, und wobei es sich bei den Rundfunksignalen um digitale Rundfunksignale oder analoge Rundfunksignale handeln kann
• Berechnen des Leistungspegels innerhalb einer bestimmten Bandbreite bei jeder vorbestimmten Schrittweite
• Speichern der Leistungspegelverteilung in einer ersten Speichereinheit
• Schätzen von Rundfunkarten im gesamten Frequenzspektrum unter Verwendung der Leistungspegelverteilung
• Speichern der geschätzten Rundfunkarten für das Frequenzspektrum in der ersten Speichereinheit
• Starten der Kanalsuche nach einem Frequenzbereich innerhalb des Frequenzspektrums
**dadurch gekennzeichnet, dass** das Verfahren darüber hinaus die folgenden Schritte umfasst:
• um Rundfunksignale zu empfangen, Abstimmen des ersten oder zweiten Kanalwählers im Hinblick auf die geschätzte Rundfunkart,
• wenn die geschätzte Rundfunkart mit der empfangenen Rundfunkart übereinstimmt, Speichern des Kanals in einer zweiten Speichereinheit und Fortsetzen der Kanalsuche innerhalb des Frequenzspektrums,
• wenn die geschätzte Rundfunkart mit der empfangenen Rundfunkart nicht übereinstimmt, auf den anderen Kanalwähler in dem System abgestimmt wird, um den Kanal in der zweiten Speichereinheit zu speichern und die Kanalsuche fortzusetzen.

2. Verfahren nach Anspruch 1, wobei, wenn der Frequenzbereich kein Signal enthält, die Kanalsuche für diesen Bereich übersprungen wird.

3. Verfahren nach Anspruch 1, wobei die Rundfunkart aus dem Wert der automatischen Verstärkungsregelung (AGC - *Automatic Gain Control*) bei einer bestimmten Mittenfrequenz und aus der Bandbreite geschätzt wird.

4. Verfahren nach Anspruch 3, wobei im Schätzvorgang für die Rundfunkart die Mittenfrequenz eines Rundfunksignals aus der Leistungspegelanalyse bestimmt wird.

5. Verfahren nach Anspruch 4, wobei der Kanalwähler in dem Abstimmvorgang auf die Mittenfrequenz eines geschätzten Rundfunksignals abgestimmt wird, um Fehler zu verhindern, die von Frequenzverschiebungen verursacht werden.

6. Verfahren nach Anspruch 1, wobei die Leistungspegel gespeichert werden, indem der bestimmte Frequenzbereich in bestimmten Schritten durchsucht wird.

7. Verfahren nach Anspruch 1, wobei die Schätzung der Rundfunkart dadurch erfolgt, dass die im ersten Speicher gespeicherten Leistungspegel analysiert werden.

8. Verfahren nach Anspruch 7, wobei ein Frequenzbereich als digitales Rundfunksignal eingeschätzt wird, wenn ein durchgehender ununterbrochener Leistungspegel mit einem angemessenen Rauschabstand festgestellt wird.

9. Verfahren nach Anspruch 7, wobei ein Frequenzbereich als analoges Signal eingestuft wird, wenn eine Veränderung eines Leistungspegels erhalten wird, die höher ist als ein Schwellenwertpegel.

10. Verfahren nach Anspruch 7, wobei ein Frequenzbereich als signalfrei eingestuft wird, wenn über diesen Frequenzbereich keine Leistung besteht.

11. Verfahren nach Anspruch 1, wobei die Schrittweite und Bandbreite konfigurierbar sind.

12. Verfahren nach Anspruch 1, wobei es sich bei dem ersten und zweiten Speicher um flüchtige Speicher handelt.

13. Verfahren nach Anspruch 1, wobei es sich bei dem ersten und zweiten Speicher um nichtflüchtige Speicher handelt.

14. Verfahren nach Anspruch 13, wobei es sich bei dem ersten und zweiten Speicher um Speicherplätze in einem nichtflüchtigen Speicher handelt.

15. System mit einem ersten und zweiten Kanalwähler zum Empfangen analoger und digitaler Signale in einem bestimmten Frequenzspektrum, Folgendes umfassend:
• Einrichtungen zum Bestimmen eines Frequenzspektrums zum Empfangen analoger und digitaler Signale
• Einrichtungen zum Durchsuchen des bestimmten Frequenzspektrums in vorbestimmten Schritten
• Einrichtungen zum Extrahieren einer Leistungspegelverteilung über das Frequenzspektrum, wobei das Frequenzspektrum Rundfunksignale enthält, und wobei es sich bei den Rundfunksignalen um digitale Rundfunksignale oder analoge Rundfunksignale handeln kann
• Einrichtungen zum Berechnen des Leistungspegels innerhalb einer bestimmten Bandbreite bei jeder vorbestimmten Schrittweite
• eine erste Speichereinheit zum Speichern der Leistungspegelverteilung
• Einrichtungen zum Einschätzen von Rundfunkarten im gesamten Frequenzspektrum unter Verwendung der Leistungspegelverteilung
• eine erste Speichereinheit zum Speichern der für das Frequenzspektrum geschätzten Rundfunkarten
• Einrichtungen zur Kanalsuche nach einem Frequenzbereich innerhalb des Frequenzspektrums
**dadurch gekennzeichnet, dass** es darüber hinaus umfasst:
• Einrichtungen zum Abstimmen auf den ersten oder zweiten Kanalwähler im Hinblick auf die geschätzte Rundfunkart
• Einrichtungen zum Entscheiden, ob die geschätzte Rundfunkart mit der empfangenen Rundfunkart übereinstimmt
• eine zweite Speichereinheit zum Speichern der gefundenen Kanäle, wenn die geschätzte Rundfunkart mit der empfangenen Rundfunkart übereinstimmt.
• wenn die geschätzte Rundfunkart mit der empfangenen Rundfunkart nicht übereinstimmt, auf den anderen Kanalwähler in dem System abgestimmt wird, um den Kanal in der zweiten Speichereinheit zu speichern und die Kanalsuche fortzusetzen.

16. System nach Anspruch 15, wobei, wenn der Frequenzbereich kein Signal enthält, die Kanalsuche für diesen Bereich übersprungen wird.

## Revendications

1. Procédé pour fournir une recherche de canal pour un système ayant un premier et un second syntoniseur pour recevoir des signaux analogiques et numériques à l'intérieur d'un spectre de fréquences donné, comprenant les étapes consistant à :
- déterminer un spectre de fréquences pour recevoir des signaux analogiques et numériques
- rechercher dans le spectre de fréquences donné par pas prédéterminés
- extraire une répartition du niveau de puissance à travers ledit spectre de fréquences, où ledit spectre de fréquences contient des signaux de diffusion, et où les signaux de diffusion peuvent être des signaux de diffusion numériques ou des signaux de diffusion analogiques
- calculer le niveau de puissance à l'intérieur d'une largeur de bande donnée à chaque grandeur de pas prédéfinie
- stocker la répartition du niveau de puissance dans une première unité de mémoire
- estimer des types de diffusion sur le spectre de fréquences entier en utilisant la répartition du niveau de puissance
- stocker lesdits types de diffusion estimés pour ledit spectre de fréquences dans la première unité de mémoire
- commencer la recherche de canal pour une plage de fréquences à l'intérieur dudit spectre de fréquences
**caractérisé en ce que**, le procédé comprend en outre les étapes consistant à :
- afin de recevoir des signaux de diffusion, syntoniser ledit premier ou ledit second syntoniseur relativement au type de diffusion estimé
- si ledit type de diffusion estimé concorde avec le type de diffusion reçu, stocker le canal dans une seconde unité de mémoire et continuer la recherche de canal à l'intérieur dudit spectre de fréquences.
- si ledit type de diffusion estimé ne concorde pas avec ledit type de diffusion reçu, syntoniser l'autre syntoniseur à l'intérieur du système pour stocker le canal dans ladite seconde unité de mémoire et pour continuer ladite recherche de canal.

2. Procédé selon la revendication 1, dans lequel, si ladite plage de fréquences ne contient pas de signal, la recherche de canal est sautée pour cette plage.

3. Procédé selon la revendication 1, dans lequel ledit type de diffusion est estimé à partir de la valeur de commande automatique de gain (AGC) au niveau d'une fréquence centrale donnée et de la largeur de bande.

4. Procédé selon la revendication 3, dans lequel, lors de ladite procédure d'estimation de type de diffusion, la fréquence centrale d'un signal de diffusion est identifiée à partir de l'analyse du niveau de puissance.

5. Procédé selon la revendication 4, dans lequel, lors de la procédure de syntonisation, le syntoniseur sera syntonisé sur ladite fréquence centrale d'un signal de diffusion estimé afin d'empêcher des défaillances causées par des déplacements de fréquence.

6. Procédé selon la revendication 1, dans lequel lesdits niveaux de puissance sont stockés en recherchant dans la plage de fréquences donnée par pas donnés.

7. Procédé selon la revendication 1, dans lequel ladite estimation du type de diffusion est effectuée en analysant les niveaux de puissance stockés dans ladite première mémoire.

8. Procédé selon la revendication 7, dans lequel, une plage de fréquences est estimée comme étant un signal de diffusion numérique, si un niveau de puissance lisse continu est observé avec un rapport signal sur bruit raisonnable.

9. Procédé selon la revendication 7, dans lequel une plage de fréquences est marquée comme un signal analogique si un changement du niveau de puissance supérieur à un niveau de seuil est obtenu.

10. Procédé selon la revendication 7, dans lequel une plage de fréquences est marquée comme pas de signal s'il n'y a pas de puissance à travers cette plage de fréquences.

11. Procédé selon la revendication 1, dans lequel ladite grandeur de pas et ladite largeur de bande sont configurables.

12. Procédé selon la revendication 1, dans lequel ladite première et ladite seconde mémoire sont des mémoires volatiles.

13. Procédé selon la revendication 1, dans lequel ladite première et ladite seconde mémoire sont des mémoires non volatiles.

14. Procédé selon la revendication 13, dans lequel ladite première et ladite seconde mémoire sont des emplacements de mémoire dans une mémoire non volatile.

15. Système ayant un premier et un second syntoniseur pour recevoir des signaux analogiques et numériques à l'intérieur d'un spectre de fréquences donné, comprenant :
- un moyen pour déterminer un spectre de fréquences pour recevoir des signaux analogiques et numériques
- un moyen pour rechercher dans le spectre de fréquences donné par pas prédéterminés
- un moyen pour extraire une répartition du niveau de puissance à travers ledit spectre de fréquences, où ledit spectre de fréquences contient des signaux de diffusion, et où les signaux de diffusion peuvent être des signaux de diffusion numériques ou des signaux de diffusion analogiques
- un moyen pour calculer le niveau de puissance à l'intérieur d'une largeur de bande donnée à chaque grandeur de pas prédéfinie
- une première unité de mémoire pour stocker la répartition du niveau de puissance
- un moyen pour estimer des types de diffusion sur le spectre de fréquences entier en utilisant la répartition du niveau de puissance
- une première unité de mémoire pour stocker lesdits types de diffusion estimés pour ledit spectre de fréquences
- un moyen pour la recherche de canal pour une plage de fréquences à l'intérieur dudit spectre de fréquences
**caractérisé en ce que**, il comprend en outre :
- un moyen pour syntoniser ledit premier ou ledit second syntoniseur relativement au type de diffusion estimé
- un moyen pour décider si le type de diffusion estimé concorde avec le type de diffusion reçu
- une seconde unité de mémoire pour stocker les canaux trouvés si ledit type de diffusion estimé concorde avec le type de diffusion reçu.
- si ledit type de diffusion estimé ne concorde pas avec ledit type de diffusion reçu, syntoniser l'autre syntoniseur à l'intérieur du système pour stocker le canal dans ladite seconde unité de mémoire et pour continuer ladite recherche de canal.

16. Système selon la revendication 15, dans lequel, si ladite plage de fréquences ne contient pas de signal, la recherche de canal est sautée pour cette plage.
